# EUROPÄISCHE PATENTSCHRIFT

(11) **EP 0 808 553 B1**
(45) Veröffentlichungstag und Bekanntmachung des Hinweises auf die Patenterteilung: **14.10.1998**
(21) Anmeldenummer: 96901230.1
(22) Anmeldetag: 02.02.1996
(51) Int. Cl.: H05K 5/02, G06F 1/18, H05K 5/04, G06F 1/16

(54) **GEHÄUSE FÜR DATENVERARBEITUNGSGERÄTE**
HOUSING FOR DATA-PROCESSING EQUIPMENT
BOITIER POUR EQUIPEMENTS INFORMATIQUES

(30) Priorität: 06.02.1995 DE 19503801
(43) Veröffentlichungstag der Anmeldung: 26.11.1997
(73) Patentinhaber: Siemens Nixdorf Informationssysteme AG, 33106 Paderborn (DE)
(72) Erfinder: NEUKAM, Wilhelm, D-86159 Augsburg (DE); SEIDEL, Bernd, D-08209 Auerbach (DE)
(74) Vertreter: Epping, Wilhelm, Dr.-Ing.
(86) Internationale Anmeldenummer: DE9600165
(87) Internationale Veröffentlichungsnummer: WO9625025

(56) Entgegenhaltungen:
- EP-A- 0 234 294
- DE-U- 9 404 470
- US-A- 5 116 261
- US-A- 5 164 886

## Beschreibung

Die Erfindung betrifft ein Gehäuse für Datenverarbeitungsgerate nach den Merkmalen des Oberbegriffs des Anspruchs 1.

Ein Gehäuse der eingangs genannten Art ist beispielsweise aus EP 0 234 294-A1 bekannt. Bei dieser Art von Gehäusen ist es einerseits erwünscht, daß sie, zumindest was die Außenverkleidung angeht, leicht montierbar sind, andererseits aber so abgesichert sind, daß eine unautorisierte Öffnung des Gehäuses nur unter Inkaufnahme einer Beschädigung der Gehäuseverkleidung durchführbar und deshalb ohne Schwierigkeit sofort erkannt werden kann. So ist beispielsweise das aus EP 0 234 294-A1 bekannte Gehäuse so aufgebaut, daß nacheinander zunächst Seitenwandteile und gegebenenfalls die Vorderwand mit Hilfe von Rastelementen befestigt werden, daß anschließend die Abdeckhaube unter Abdeckung der Befestigungselemente von Vorder- und Seitenwandteilen aufgesetzt und festgeschraubt wird, daß als nächstes die Rückwand, wiederum unter Abdeckung der Befestigungsschrauben des Abdeckhaubenteils eingehängt und rastend befestigt wird und daß schließlich die Rückwand mit Hilfe eines schlüsselbetätigbaren Sperrschlosses verriegelbar ist. Ein derartiges Gehäuse kann deshalb nur noch von Personen ordnungsgemäß geöffnet werden, die im Besitz eines passenden Schlüssels sind.

Ausgehend von diesem Stand der Technik liegt nun der vorliegenden Erfindung die Aufgabe zugrunde, ein mit Seitenwänden und Abdeckhaubenteils allseitig verschlossenes Gehäuse so zu gestalten, daß die Außenmontage des Gerätes ohne Werkzeug durchführbar und das Gehäuse nur mit Hilfe eines Schlüssels und auch dann nicht auf direktem Wege geöffnet werden kann.

Die Lösung dieser Aufgabe ergibt sich erfindungsgemäß durch die Merkmale des Anspruchs 1. Vorteilhafte Weiterbildungen der Erfindung sind in Unteransprüchen angegeben. Der Vorteil eines derart aufgebauten Gehäuses besteht darin, daß unter Verzicht auf Schraubbefestigungen nur ein Anhängen und Aufschieben einzelner Gehäuseverkleidungselemente notwendig ist. Ein weiterer Vorteil besteht darin, daß das Gehäuse auch bei geöffnetem Schloß nicht unmittelbar über das das Schloß enthaltende Gehäusewandteil zugänglich wird, sondern über ein anderes Gehäuseteil, im vorliegenden Fall über das Abdeckhaubenteil, das erst durch das Öffnen des Schlosses entriegelt und abgenommen werden kann.

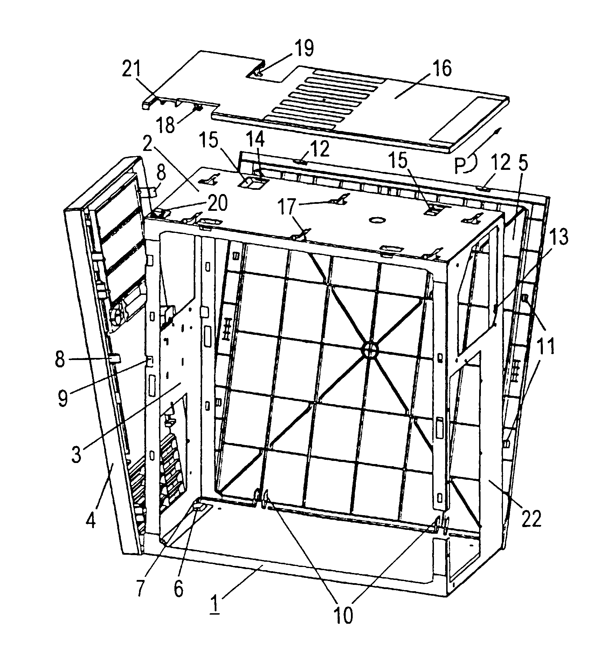

Im folgenden wird ein Ausführungsbeispiel der Erfindung anhand der Zeichnung näher erläutert.

Die Figur zeigt in einer perspektivischen Explosionsdarstellung den prinzipiellen Aufbau eines Gehäuses für ein Gerät der Datentechnik, beispielsweise für einen Personalcomputer in Tower-Bauweise. Das Gehäuse besteht aus einem quaderförmigen Rahmengestell 1 mit Deckfläche 2, Vorderwand 3, Rückwand 22 und offenen Seitenflächen. Zur Verkleidung der beide Seitenflächen sind jeweils Seitenwandteile 5 vorgesehen, wobei das der vorderen Seitenfläche zugeordnete Seitenwandteil aus Gründen der besseren Übersichtlichkeit der Gesamtanordnung in der Zeichnung nicht dargestellt ist.

Die Endmontage des im Inneren mit Flachbaugruppen, Stromversorgungseinrichtungen und sonstigen Funktionseinheiten bestückten Rahmengestells 1 erfolgt nun in der Weise, daß zunächst die Frontblende 4 mittels zweier am unteren Ende vorgesehener Haken 6 in entsprechende Durchbrüche 7 an der Vorderwand 3 hinter dem Rahmengestell 1 einhakt und anschließend gegen die Vorderwand 3 geschwenkt wird. Dabei umgreifen jeweils zwei an den Längskanten der Frontblende vorgesehene Rasthaken 8 das Rahmengestell und rasten in dort vorgesehene Durchbrüche 9 ein. Nach der Befestigung der Frontblende 4 erfolgt die Montage der beiden Seitenwandteile derart, daß an der Unterkante der Seitenwandteile 5 vorgesehene Haltehaken 10 den unteren Querträger des Rahmengestells 1 hintergreifen und an den Seitenkanten sowie an der Oberkante des gegen das Rahmengestell 1 geschwenkten Seitenwandteils 5 mehrere Schnapphaken 11,12 in zugehörige Durchbrüche 13,14 einrasten. Im Bereich der oberen Schnapphaken 12 weist die Deckfläche 2 des Rahmengestells 1 zusätzliche Durchbrüche 15 auf, über die diese Schnapphaken 12 wieder entriegelbar sind. Nach der Montage der Seitenwandteile sind die Rasthaken 8 der Frontblende 4 abgedeckt und demzufolge nicht mehr zugänglich.

Nun folgt als nächstes die Montage eines Abdeckhaubenteils 16 auf der Deckfläche 2 des Rahmengestells 1. Zu diesem Zweck weist die Deckfläche 2 mehrere schlüssellochartige Durchbrüche 17 auf, in die an der Innenseite des Abdeckhaubenteils 16 vorgesehene Greifhaken 18 eintauchen. Die Durchbrüche 17 sind derart angeordnet, daß das Abdeckhaubenteil 16 nach dem Aufsetzen in einer seitlich versetzten Stellung anschließend in eine zur Deckfläche 2 deckungsgleiche Endstellung verschiebbar ist (siehe Pfeil P). An der Innenseite des Abdeckhaubenteils 16 sind an der dem hinteren Seitenwandteil zugewandten Längskante in Höhe der Schnapphaken 12 jeweils winkelförmige Rastelemente 19 vorgesehen, die in die den Schnapphaken 12 zugeordnete Durchbrüche 15 in der Deckfläche 2 eintauchen und beim seitlichen Verschieben des Abdeckhaubenteils 16 unter diese Schnapphaken 12 greifen. Auf diese Weise werden die oberen Schnapphaken 12 der Seitenwandteile nicht nur abgedeckt, sondern, soweit es die Schnapphaken des hinteren Seitenwandteils 5 betrifft, zusätzlich noch mechanisch verriegelt. Um nun auch noch das Abdeckhaubenteil 16 ausreichend zu verriegeln, ist in der Deckfläche 2 ein in einer schachtartigen Führung senkrecht zur Ebene der Deckfläche 2 bewegbarer Stößel 20 vorgesehen, der mittels eines Sperrschlosses aus der Deckfläche 2 herausschiebbar ist, und zwar vor ein an der Innenseite des Abdeckhaubenteils 16 vorgesehenes Sperrelement 21, so daß das Abdeckhaubenteil 16 im Sperrzustand des Stößels 20 nicht mehr zurückschiebbar ist. Vorzugsweise befindet sich das den Stößel 20 zum Beispiel über einen exzentrisch gelagerten Hebel bewegbare Sperrschloß in der Frontblende 4.

## Patentansprüche

1. Gehäuse für Datenverarbeitungsgeräte, bestehend aus einem quaderförmigen Rahmengestell (1) mit Deckfläche (2) und einer wenigstens den Anschlußsteckerbereich aus sparenden Rückwandverkleidung, an dem Seitenwandteile (5), ein Abdeckhaubenteil (16) und eine Frontblende (4) mit Sperrschloß befestigt sind, **gekenzeichnet durch** die Kombination folgender Merkmale:
a) die Frontblende (4) weist am unteren Ende wenigstens ein das Rahmengestell (1) hintergreifendes Halteelement (10) und wenigstens zwei gegenüberliegende Rahmenteile umgreifende und in Durchbrüche (9) im Rahmengestell eintauchende Rasthaken (8) auf,
b) die Seitenwandteile weisen am unteren Rand das Rahmengestell hintergreifende Haltehaken (10) und jeweils an den seitlichen und oberen Rahmenteilen in zugehörige Durchbrüche eintauchende Schnapphaken (11,12) auf, wobei die oberen Schnapphaken (12) über in der Deckfläche (2) vorgesehene Durchbrüche (15) entriegelbar sind,
c) die Deckfläche (2) weist mehrere schlüssellochartige (17) Durchbrüche zur Aufnahme von an der Innenseite des Abdeckhaubenteils vorgesehenen Greifhaken (18) auf, wobei die Durchbrüche (17) derart angeordnet sind, daß das Abdeckhaubenteil (16) nach dem Aufsetzen in einer seitlich versetzten Stellung in eine zur Deckfläche (2) des Rahmengestells (1) deckungsgleiche Endstellung verschiebbar ist,
d) das an der Frontblende (4) vorgesehene Sperrschloß ist mit einem Sperriegel (20) gekoppelt, der im Sperrzustand ein Zurückschieben des Abdeckhaubenteils blockiert.

2. Gehäuse nach Anspruch 1,
**dadurch gekennzeichnet,** daß die Befestigung der Frontblende (4), des Abdeckhaubenteils (16) und der Seitenwandteile (5) in der Weise erfolgt, daß die Seitenwandteile (5) die Rasthaken (8) der vorher montierten Frontblende (4) und das Abdeckhaubenteil (16) die Schnapphaken (12) der vorher montierten Seitenwandteile (5) abdecken.

3. Gehäuse nach Anspruch 1 oder 2,
**dadurch gekennzeichnet,** daß an der Innenseite des Abdeckhaubenteils winkelförmige Rastelemente (19) vorgesehen sind, die in die den Schnapphaken (12) der Seitenwandteile (5) zugeordneten Durchbrüche (15) in der Deckfläche (2) eintauchen und beim seitlichen Verschieben des Abdeckhaubenteils (16) unter die Schnapphaken (12) greifen.

## Claims

1. Housing for data-processing equipment, comprising a cuboidal frame (1) with a top surface (2) and a rear wall panelling, which leaves at least the connecting plug region exposed and on which there are fastened side wall sections (5), a cover section (16) and a front panel (4) with a lock, characterized by the combination of the following features:
a) a front panel (4) has at the lower end at least one retaining element (10), engaging behind the frame (1), and at least two locking catches (8), engaging around opposite parts of the frame and entering into openings (9) in the frame,
b) the side wall sections have at the lower edge retaining catches (10), engaging behind the frame, and snap-in catches (11,12), respectively on the lateral and upper parts of the frame and entering into associated openings, the upper snap-in catches (12) being able to unlock via openings (15) provided in the top surface (2),
c) the top surface (2) has a plurality of keyhole-like openings (17) for receiving gripping catches (18), provided on the inner side of the cover section, the openings (17) being arranged in such a way that, after fitting on in a laterally offset position, the cover section (16) is displaceable into an end position, congruent with the top surface (2) of the frame (1),
d) the lock, provided on the front panel (4), is coupled to a bolt (20), which blocks sliding back of the cover section when in the locked state.

2. Housing according to Claim 1, characterized in that the fastening of the front panel (4), of the cover section (16) and of the side wall sections (5) takes place by the side wall sections (5) covering the locking catches (8) of the previously assembled front panel (4) and by the cover section (16) covering the snap-in catches (12) of the previously assembled side wall sections (5).

3. Housing according to Claim 1 or 2, characterized in that on the inner side of the cover section there are provided angular catch elements (19), which enter into the openings (15) in the top surface (2) which are assigned to the snap-in catches (12) of the side wall sections (5) and engage under the snap-in catches (12) during the lateral displacing of the cover section (16).

## Revendications

1. Boîtier pour équipements informatiques, constitué d'un châssis (1) parallélépipédique pourvu d'une face (2) de recouvrement et d'un habillage de paroi arrière évidé au moins dans la région des connecteurs, châssis sur lequel des panneaux (5) latéraux, un capot (16) de recouvrement et un cache (4) avant sont fixés en étant pourvus d'une serrure de sûreté,
**caractérisé** par la combinaison des caractéristiques suivantes :
a) le cache (4) avant comporte au moins un élément (6) de retenue, prévu à son extrémité inférieure et s'engageant derrière le châssis (1), et au moins deux crochets (8) à enclenchement s'engageant autour de deux parties opposées du châssis et pénètrant dans des ouvertures (9) du châssis,
b) les panneaux latéraux comportent des crochets (10) de retenue, prévus sur leur bord inférieur et s'engageant derrière le châssis, et des crochets (11, 12) à déclic pénétrant respectivement dans des ouvertures associées sur les parties latérales et la partie supérieure du châssis, les crochets (12) supérieurs à déclic pouvant être déverrouillés en y accédant par des ouvertures (15) prévues dans la face (2) de recouvrement,
c) la face (2) de recouvrement comporte plusieurs ouvertures (17) du genre trous de serrure, qui sont destinées à recevoir des crochets (18) preneurs prévus sur le côté intérieur du capot de recouvrement, les ouvertures (17) étant disposées de telle sorte que le capot (16) de recouvrement peut, après avoir été mis en place dans une position latéralement décalée, être coulissé dans une position finale en recouvrement avec la face (2) de recouvrement du châssis (1),
d) la serrure de sûreté prévue sur le cache (4) avant est couplée à un verrou (20) de sûreté qui, lorsqu'il est verrouillé, empêche le capot de recouvrement d'être retiré par coulissement.

2. Boîtier suivant la revendication 1, **caractérisé** en ce que la fixation du cache (4) avant, du capot (16) de recouvrement et des panneaux (5) latéraux s'effectue de telle sorte que les panneaux (5) latéraux recouvrent les crochets (8) à enclenchement du cache (4) avant préalablement monté, et que le capot (16) de recouvrement recouvre les crochets (12) à déclic des panneaux (5) latéraux préalablement montés.

3. Boîtier suivant la revendication 1 ou 2, **caractérisé** en ce qu'il est prévu, sur le côté intérieur du capot de recouvrement, des éléments (19) coudés à enclenchement, qui pénètrent dans les ouvertures (15) de la face (2) de recouvrement associées aux crochets (12) à déclic des panneaux (5) latéraux et qui, lors du coulissement latéral du capot (16) de recouvrement, s'engagent sous les crochets (12) à déclic.
